# EUROPEAN PATENT APPLICATION

(11) **EP 4 354 257 A1**
(43) Date of publication of application: **17.04.2024**
(21) Application number: 22854992.9
(22) Date of filing: 12.05.2022
(51) Int. Cl.: G06F 1/18

(54) **CASE AND EDGE DEVICE**

(30) Priority: 11.08.2021 CN 202110919909; 18.11.2021 CN 202111368342
(71) Applicant: Huawei Technologies Co., Ltd., Longgang Shenzhen, Guangdong 518129 (CN)
(72) Inventor: LIU, Chenghua, Shenzhen, Guangdong 518129 (CN); LI, Xiaochu, Shenzhen, Guangdong 518129 (CN); LUO, Min, Shenzhen, Guangdong 518129 (CN); YAN, Xiaolong, Shenzhen, Guangdong 518129 (CN)
(74) Representative: Körber, Martin Hans
(86) International application number: PCT/CN2022/092402
(87) International publication number: WO 2023/016003

(57) **Abstract**

A chassis is provided. The chassis includes a cabinet and a heat exchange component. The heat exchange component is disposed in a space enclosed by the cabinet. The space in the cabinet is divided into a first space and a second space for placement an electronic device. Heat transfer is performed between the first space and the second space by using the heat exchange component. A first air inlet and a first air outlet are disposed in the first space, and an airflow entering from the first air inlet flows through a first surface of the heat exchange component and exits from the first air outlet. In this way, an effective temperature control solution is provided for an edge device.

## Description

### CROSS-REFERENCE TO RELATED APPLICATIONS

This application claims priorities to Chinese Patent Application No. 202110919909.7, filed with the China National Intellectual Property Administration on August 11, 2021 and entitled "COMPUTER SYSTEM AND METHOD RELATED TO HEAT DISSIPATION CONTROL", and to Chinese Patent Application No. 202111368342.5, filed with the China National Intellectual Property Administration on November 18, 2021 and entitled "CHASSIS AND EDGE DEVICE", which are incorporated herein by reference in their entireties.

### TECHNICAL FIELD

This application relates to the field of computers, and specifically, to a chassis and an edge device.

### BACKGROUND

With continuous development of edge scenarios such as information exchange of a vehicle to everything (vehicle to everything, V2X), augmented reality (augmented reality, AR)/virtual reality (virtual reality, VR), and video analysis, especially in a harsh environment with mine and wharf, an edge device such as an edge server needs to meet a dustproof and waterproof requirement to work normally. In addition, an outdoor edge device should have an effective temperature control function. A temperature control system of an existing edge device usually uses direct ventilation to implement temperature control inside a chassis. In other words, an air inlet and an air outlet are respectively provided on opposite side walls of the chassis of the edge device, so that an airflow enters the chassis from the air inlet, and as the airflow flows, heat of an electronic device is transferred to the outside of the chassis through the air outlet, to implement heat dissipation of the edge device. The foregoing direct ventilation can dissipate heat of the electronic device in the chassis, and has low costs. However, a temperature control function achieved by the edge device is poor, and temperature control under an extreme temperature environment condition cannot be implemented. For example, the edge device cannot work normally under an extreme condition because an environment temperature for the edge device to work normally is limited. Therefore, how to provide an effective temperature control solution for the edge device becomes a technical problem to be urgently resolved.

### SUMMARY

This application provides a chassis and an edge device, to provide an effective temperature control solution for the edge device.

According to a first aspect, a chassis is provided, including a cabinet and a heat exchange component disposed in space enclosed by the cabinet. The heat exchange component divides a space in the cabinet into a first space and a second space for placement of an electronic device. Heat transfer is performed between the first space and the second space by using the heat exchange component. A first air inlet and a first air outlet are provided in the first space, an airflow entering from the first air inlet flows through a first surface of the heat exchange component and exits from the first air outlet, and the first surface is located in the first space.

Because internal space formed by the cabinet of the edge device may be divided into two independent spaces by the heat exchange component: the first space and the second space. The first space is provided with the first air inlet and the first air outlet, and the first air inlet and the first air outlet are respectively configured to communicate with an external environment. An airflow flowing between the first air inlet and the first air outlet may enable heat in the first space to be transferred to the external environment. In this way, the first space may form external circulation heat dissipation space, to implement heat transfer with the external environment. The second space is for placement of an electronic device. Heat generated by the electronic device in a running process may be first transferred to the first space through the heat exchange component, and then transferred to the external environment through an airflow in the first space. Because the first space and the second space are independent of each other, when an external environment temperature is low, an external airflow may be reduced to directly act on the second space, causing a large amount of heat loss in the second space. Heat generated by the electronic device located in the second space due to power consumption may be transferred to the external environment through the heat exchange component and the first space, to dissipate heat of the electronic device. In this way, the chassis can implement a bidirectional adjustment, and achieve a better temperature control effect, to enable an edge device using the chassis to have better temperature applicability, and broaden a temperature application range of the edge device.

In a possible implementation, the heat exchange component may determine placement of the heat exchange component in the chassis based on a height of a to-be-placed electronic device in the edge device and a size of a printed circuit board on which the electronic device is located. When it is ensured that the second space is sufficient to place the electronic device, sizes of the first space and the second space are properly set, so that heat in the second space may be transferred to the first space by using the heat exchange component, and is transferred to the outside of the chassis by using the first space, to achieve an effective heat dissipation function.

In another possible implementation, when the heat exchange component is specifically disposed, the heat exchange component may be disposed in a length direction or a width direction of the cabinet. For example, when the heat exchange component is disposed along the length direction of the cabinet, the heat exchange component may divide a space in the cabinet into two independent spaces in the width direction of the cabinet. When the heat exchange component is disposed along the width direction of the cabinet, the heat exchange component may divide a space in the cabinet into two independent spaces in the length direction of the cabinet. Therefore, the space in the chassis is divided into two parts, and the second space for placement of the electronic device may be sealed, to be dustproof and waterproof, and avoid a fault of the electronic device or the printed circuit board with the electronic device caused by a contaminant. Then, the heat is transferred to the outside of the chassis by using an airflow in the first space, to implement heat dissipation.

In another possible implementation, a baffle plate is disposed outside of the cabinet, and the baffle plate is configured to control the airflow from the first air inlet to enter the cabinet through corner air intake. Because the corner air intake is used, a flow rate of the airflow entering the first space can be controlled, to reduce heat dissipation in a low-temperature environment, improve a heat insulation effect in the low-temperature environment, and enable the edge device to run normally in the low-temperature environment. A problem that the edge device cannot run normally due to high heat dissipation at a low temperature can be resolved by changing air intake in the chassis. Therefore, the chassis has advantages of simple structure and low cost.

In another possible implementation, the baffle plate may be an L-shaped plate or an arc-shaped plate. By disposing the L-shaped plate or the arc-shaped plate outside the chassis, the corner air intake may be used by the chassis to increase a path needed for the airflow to enter the first space, and a flow rate of the airflow entering the first space can be controlled.

In another possible implementation, the first air inlet may be provided on a first end plate of the first space, and runs through the first end plate along a thickness direction of the first end plate. The baffle plate is connected to the first end plate, and the baffle plate and the first end plate enclose to form an air guide passage, at least one air guide opening exists in the air guide passage. An included angle is provided between an air intake direction of the air guide opening and an air intake direction of the first air inlet, to enable an airflow entering the air guide passage through the air guide opening to enter the chassis from the first air inlet after the airflow is diverted. By using the foregoing corner air intake, a flow rate of an airflow entering the first space within per unit time can be effectively controlled, so that the edge device can effectively avoid temperature loss in the chassis in a low-temperature environment, to achieve a better temperature control effect.

In another possible implementation, the first air inlet is provided on a first side wall of the first space, and runs through the first side wall along a thickness direction of the first side wall. The first air outlet is provided on a second end plate of the first space. An included angle is provided between the first side wall and the second end plate, to enable the airflow entering from the first air inlet to exit from the first air outlet after the airflow is diverted. The first side wall and the second end plate are in a non-parallel state. When the first air inlet is provided on the first side wall and the first air outlet is provided on the second end plate, the first air inlet and the first air outlet are in a non-parallel state. In this way, an airflow entering from the first air inlet needs to exit from the first air outlet after the airflow is diverted, so that angle air intake in the cabinet can be implemented. By setting the corner air intake, a path needed for the airflow to enter the first space may be increased, to control an amount of air entering the first space within per unit time, to control air intake speed in the first space.

In another possible implementation, when the first side wall and the second end plate are specifically disposed, the first side wall may be perpendicular to the second end plate. In this way, angle air intake at an angle of 90 degrees can be implemented between the first air inlet and the first air outlet, and a flow rate of an airflow can be controlled to a maximum extent in a condition of natural cross ventilation. Therefore, a flow rate and flow of the airflow in the first space are controlled, heat loss in a low-temperature environment is reduced, to achieve a better temperature control effect.

In another possible implementation, a first fan group may be disposed in the first space, and an airflow entering the first space from the first air inlet may flow to the first air outlet under an action of the first fan group. When an external environment temperature is high, the first fan group may be in a high-load running state, such as a full-load running state, to increase a flow rate of the airflow entering the first space, so that high ventilation can be maintained in per unit time, and heat in the second space can be transferred at a faster speed. Therefore, the first fan group may be disposed to increase the flow rate of the airflow in the first space in the high-temperature environment, improve a heat dissipation effect, and discharge heat generated by the electronic device in the second space in time, and enable the edge device to run normally at a high temperature.

In another possible implementation, a heating component is disposed in the second space, and the heating component is configured to increase a temperature of the second space in a low-temperature environment. The heating component may include a heating film, and the heating film may be disposed in the second space. For example, the heating film is disposed on at least one position in a bottom wall or a side wall of the second area. Heat may be provided, by disposing the heating film, for the second space in a low-temperature environment through the heating film, so that a terminal device in the second space can start and run normally. There may be one, two, or more heating films. The heating film may be set based on a specific quantity and position of the terminal device. By adding the heating film in the second space, when the edge device is in a low-temperature environment, the chassis may be heated by using the heating film, to ensure that the electronic device in the second space is working.

In another possible implementation, the chassis may further include an opening and closing component. The opening and closing component is connected to the cabinet, and the opening and closing component is configured to control passage of an airflow between the first air inlet and the first air outlet, to achieve a temperature control function in the chassis. In this way, when an external environment temperature is low, the opening and closing component automatically blocks flow of the airflow in the first space, reduces heat dissipation, and enables the edge device to run normally in a low-temperature environment. When the external environment temperature is high, the opening and closing component automatically enables flow of the airflow in the first space, improves heat dissipation, and enables the edge device to run normally in a high-temperature environment.

In another possible implementation, when the opening and closing component is specifically disposed, the opening and closing component may be in a first structure when a temperature in the cabinet is higher than a first temperature, where the first structure enables flow of the airflow between the first air inlet and the first air outlet. The opening and closing component is in a second structure when the temperature in the cabinet is lower than a second temperature, where the second structure blocks flow of the airflow between the first air inlet and the first air outlet.

The first temperature may be the same as the second temperature.

Optionally, the first temperature may be different from the second temperature, and the first temperature is higher than the second temperature.

In another possible implementation, when the opening and closing component is specifically disposed, the opening and closing component may be disposed at the first air outlet, and opening and closing of the first air outlet is controlled through the opening and closing component. When the opening and closing component closes, because heat dissipated by the electronic device increases a temperature of an airflow in the chassis, heat insulation may be provided for the chassis, to ensure that the electronic device in the chassis can work normally. When the opening and closing component opens, the airflow may exit the chassis through the air outlet, and then the heat generated by the electronic device is transferred to the outside of the chassis, to implement heat dissipation. Therefore, the opening and closing component is used to implement temperature control.

In another possible implementation, the opening and closing component includes a shutter. The shutter includes a blade. The blade is connected to the cabinet. A material of the blade is a memory alloy. The blade expands when a temperature of the blade is higher than a third temperature, to open the first air outlet, and the blade shrinks when a temperature of the blade is lower than the third temperature, to close the first air outlet. In this implementation, the opening and closing component is the shutter, and the blade of the shutter is made of the memory alloy. Therefore, when a temperature inside the cabinet is high, for example, the temperature of the blade is higher than the third temperature, the blade may be in an expansion state, and the first air outlet opens. When the temperature inside the cabinet is low, for example, the temperature of the blade is lower than the third temperature, the shutter may be closed by using a shape memory characteristic of the memory alloy. In this implementation, the shutter is opened and closed by using the memory alloy blade, without disposing additional control electronic device, for example, no temperature detection electronic device or driving electronic device is needed. Therefore, this implementation has advantages of simple structures, easy assembly, and low costs.

In another possible implementation, the opening and closing component includes a shutter. The shutter includes a blade and a pull cable connected to the blade. The pull cable is fixedly connected to the cabinet, and the blade is rotatably connected to the cabinet. A control member is disposed on the pull cable, and the control member is a control member made of a memory alloy. The control member expands when a temperature of the control member is higher than a fourth temperature, and the pull cable drives the blade to rotate to enable the first air outlet to be in an open state. The control member shrinks when a temperature of the control member is lower than the fourth temperature, and the pull cable drives the blade to rotate to enable the first air outlet to be in a closed state. In this implementation, the control member is made of a memory alloy. When the control member expands, the control member drives, by using the pull cable, the blade to rotate to enable the shutter to be in an open state. When the control member shrinks, the control member drives, by using the pull cable, the blade to rotate to enable the shutter to be in a closed state. In this way, the opening and the closing of the first air outlet may be implemented by using the structure, so that the first air outlet is opened when the edge device needs to dissipate heat, to enable an airflow carrying heat to exit from the cabinet as soon as possible, to implement heat dissipation. The first air outlet is closed when the edge device needs to be performed heat insulation, to avoid that a temperature of the chassis is excessively low due to heat loss and normal working of the electronic device is affected, to achieve an effective temperature control function.

In another possible implementation, the control member is a memory alloy spring. When the temperature inside the cabinet is high and the temperature of the control member is higher than the fourth temperature, the memory alloy spring is in a stretching state. The blade rotates to an opening position under an action of the pull cable. In this case, the blade may be in a horizontal state, and the shutter is opened. When the environment temperature inside the cabinet is low and the temperature of the control member is lower than the fourth temperature, the memory alloy spring shrinks, and a tension is applied to the pull cable. The blade rotates to a closed position under the action of the pull cable. In this case, the blade may be in a vertical state, and the shutter is closed. In this implementation, the shutter is opened and closed by using the memory alloy spring, without disposing additional control electronic device, for example, no temperature detection device or driving device is needed. Therefore, this implementation has advantages of simple structures, easy assembly, and low costs.

In another possible implementation, a heating component is disposed in the second space, and the heating component is configured to increase a temperature of the second space in a low-temperature environment. The heating component may include a heating film, and the heating film may be disposed in the second space. Specifically, when the heating film is disposed, the heating film may be disposed on an inner wall of the second space, for example, may be disposed on at least one position of a bottom wall, a side wall, or a top wall of the second space. Preferably, the heating film may be disposed on at least one position of the bottom wall or the side wall of the second space. Heat may be provided, by disposing the heating film, for the second space in a low-temperature environment through the heating film, so that the edge device in the second space can start and run normally. There may be one, two, or more heating films. The heating film may be set based on a specific quantity and position of the terminal device. The heating film is disposed in the second space, so that a temperature in the chassis can be effectively controlled in an extremely cold environment, and normal running of the electronic device can be ensured.

In another possible implementation, a second fan group is disposed in the second space, and an airflow in the second space flows under an action of the second fan group. A flow rate and a flow direction of the airflow in the second space may be controlled by disposing the second fan group, to control that the airflow carrying heat may flow through a surface of the heat exchange component, so that the heat is transferred to the first space, and then the first space transfers the heat to an outside of the chassis, thereby improving a heat exchange effect.

In another possible implementation, the heat exchange component includes a heat exchange plate. A first air passage is disposed on a side that is of the heat exchange plate and that faces the first space. A second air passage is disposed on a side that is of the heat exchange plate and that faces the second space. The first air passage is used for flow of an airflow in the first space, and the second air passage is used for flow of an airflow in the second space. When the heat exchange plate is specifically disposed, the heat exchange plate may be an S-shaped heat exchange plate or an arch-shaped heat exchange plate. A first surface of the heat exchange plate is disposed facing the first space and forms a part of a side wall of the first air passage, and a second surface of the heat exchange plate is disposed facing the second space and forms a part of a side wall of the second air passage. The S-shaped heat exchange plate or the arch-shaped heat exchange plate may increase a contact area between the first air passage and the second air passage, to improve a heat exchange effect.

In another possible implementation, the heat exchange component further includes a partition plate. The partition plate is disposed on a side that is of the heat exchange plate and that faces the second space. For example, the partition plate may be connected to the second surface of the heat exchange plate, a gap is disposed between the partition plate and the heat exchange plate, and the gap forms the second air passage. In this case, the partition plate is provided with a second air inlet and a second air outlet, and the airflow in the second space enters the second air passage through the second air inlet, and enters the second space through the second air outlet after flowing through the second air passage. The partition plate is disposed in the heat exchange component to form the second air passage, so that the heat exchange component can transfer heat of the electronic device to the first space, and then transfer the heat to the outside of the chassis in an external circulation mode of the first space, to implement heat dissipation for the electronic device in the edge device.

In another possible implementation, a direction from the first air inlet to the first air outlet is a first direction, a direction from the second air inlet to the second air outlet is a second direction, and the first direction is opposite to the second direction. The structure can facilitate a full exchange of heat and improve a heat exchange effect.

In another possible implementation, the chassis is a chassis of the edge device, and the edge device is a device configured to implement edge computing.

In another possible implementation, the edge device may include, for example, an edge server, an edge small cell, an AI server, an AI accelerator card, a base station device, an intelligent terminal, or another device configured for edge computing.

According to a second aspect, an edge device is provided. The edge device includes the chassis according to any one of the first aspect or the possible implementations of the first aspect of this application.

In this application, based on the implementations according to the foregoing aspects, the implementations may be further combined to provide more implementations.

### BRIEF DESCRIPTION OF DRAWINGS

FIG. 1 is a schematic diagram of a structure of a chassis from a first perspective according to this application;
FIG. 2 is a schematic diagram of a structure of an internal top view of a chassis according to an embodiment of this application;
FIG. 3 is a schematic diagram of a structure of a second perspective of a chassis according to this application;
FIG. 4 is a schematic diagram of a structure of a first air inlet according to an embodiment of this application;
FIG. 5 is a schematic diagram of a structure of an opening and closing component according to an embodiment of this application;
FIG. 6 is a schematic diagram of a structure of some blades of an opening and closing component in a closed state according to an embodiment of this application;
FIG. 7 is a schematic diagram of a structure of an opening and closing component according to another embodiment of this application;
FIG. 8 is a schematic diagram of a structure of a side view of a heat exchange component according to an embodiment of this application;
FIG. 9 is a schematic diagram of a structure of a heat exchange plate according to an embodiment of this application;
FIG. 10 is a schematic diagram of a structure of a heat exchange plate according to another embodiment of this application;
FIG. 11 is a schematic diagram of a structure of a side view of a heat exchange component according to an embodiment of this application;
FIG. 12 is a schematic diagram of a three-dimensional structure inside a chassis according to an embodiment of this application; and
FIG. 13 is a schematic diagram of a structure of an internal top view of a terminal device according to an embodiment of this application.

### Reference numerals:

10-chassis; 11-cabinet; 111-top panel; 112-bottom panel;
113-front end plate; 114-rear cover plate; 115-first side panel; 116-second side panel;
117-air intake baffle plate; 12-first space; 121-first air inlet; 122-first air outlet;
12a-first end plate; 12b-second end plate; 12c-first side wall; 12d-second side wall;
13-second space; 131-second air inlet; 132-second air outlet; 14-first fan group;
15-second fan group; 16-heating component; 20-heat exchange component; 21-heat exchange plate;
211-middle partition plate; 212-dental plate; 213-first air passage; 214-second air passage;
22-partition plate; 30-opening and closing component; 31-shutter; 311-blade;
312-frame; 313-pull cable; 314-control member; 315-fixed rod;
100-edge device; 101-electronic device.

### DESCRIPTION OF EMBODIMENTS

For ease of understanding, terms in this application are first explained.

An edge scenario is a service scenario where edge computing is used for performing data process. The edge computing is a new service in the 5^{th} generation (5^{th} Generation, 5G) mobile communication and artificial intelligence (artificial intelligence, AI) era, achieving functions in service scenarios such as augmented reality AR, virtual reality VR, and autonomous driving. The foregoing service scenarios have strong requirements on latency and network bandwidth. In a conventional centralized cloud computing scenario, all data is stored in a great data center. Due to restrictions of geographical location and network transmission, requirements such as low latency and high bandwidth of the new services cannot be met. Facing inherent limitation of the conventional centralized cloud computing, the edge computing gradually becomes a good choice for the new services. The edge computing establishes sites close to terminal application to extend a centralized cloud computing capability to an edge side to the maximum extent, effectively resolving the foregoing latency and bandwidth problems.

An edge device is a device that implements the edge computing. The edge device includes an edge server, an edge small cell, an AI server, an AI accelerator card (for example, an AI inference card or an AI training card), a device that disposes the AI accelerator card, a base station device, an intelligent terminal (for example, a mobile device such as a smartphone or a Pad that may be used to perform the edge computing), or another device used for the edge computing. For ease of description, the following uses an edge server as an example.

For an edge server disposed outdoors, because existence of contaminants such as dust and other contaminants outdoors can corrode an electronic device or a circuit board of the edge device, causing problems such as electronic device damage or circuit board short circuit. An electronic device and a printed circuit board (printed circuit board, PCB) where the electronic device is located is also corroded by natural factors such as rain and snow. Therefore, a chassis of the edge server needs to cope with various harsh environments to meet a dustproof and waterproof function and a requirement for temperature control. In the chassis provided in this application, space in the cabinet may be divided into a first space and a second space by using a heat exchange component. The first space and the second space are independent of each other, the first space may be connected to outside to form an external circulation air passage, and the second space is relatively closed to achieve a dustproof and waterproof effect, to place various electronic devices of the edge server. In addition, the chassis provided in this application may further provide a temperature control function adaptable to various environments. In a high-temperature environment, the edge device can effectively control heat dissipation of the electronic device. When a heated airflow in the second space flows through the heat exchange component, heat may be transferred by the heat exchange component to the first space, and be transferred to the outside of the chassis through the first space. In a low-temperature environment, the edge device can control a temperature inside the chassis by using an opening and closing component or a heating component to ensure that the electronic device can work properly.

The following further describes the technical solutions provided in this application with reference to the accompanying drawings.

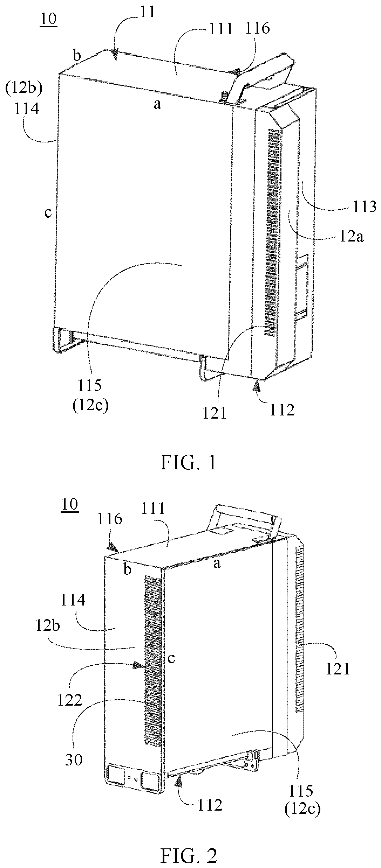

FIG. 1 is a schematic diagram of a structure of a first perspective of a chassis of an edge server according to this application. The first perspective is a side front perspective of the chassis. As shown in the figure, an external shape of a chassis 10 may be a cuboid structure, and may include a, b, and c sides along length, width, and height directions of the chassis 10. Correspondingly, the chassis 10 may include two ab panels, two be panels, and two ac panels. For ease of description, in two ab panels, one is a top panel 111 of the chassis, and the other is a bottom panel 112 of the chassis; in two be panels, the other is a front end plate 113 of the chassis, and the other is a rear cover plate 114 of the chassis; and in two ac panels, one is a first side panel 115 of the chassis, and the other is a second side panel 116 of the chassis.

Optionally, an external structure of the chassis 10 may also be a square structure, or may be set to another type of structure based on different electronic devices disposed in the chassis 10.

FIG. 2 is a schematic diagram of a structure of a second perspective of a chassis of an edge server according to this application. The second perspective is a side rear perspective of the chassis. A difference between FIG. 2 and FIG. 1 lies only in perspective. For brevity, details are not described herein again.

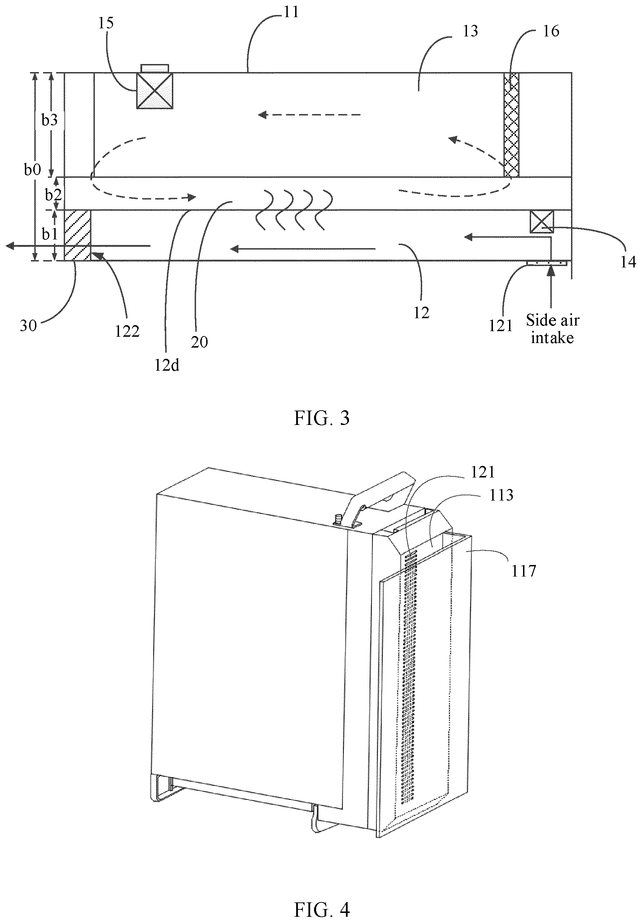

With reference to FIG. 3, the following further describes a temperature control system and a temperature control principle in the edge device to be protected in this application. FIG. 3 is a schematic diagram a structure of an internal top view of a chassis in an edge device based on this application. As shown in the figure, the chassis 10 includes a cabinet 11. Refer to FIG. 1 and FIG. 2 together, the cabinet 11 may be formed by defining the top panel 111, the bottom panel 112, the front end plate 113, the rear cover plate 114, the first side panel 115, and the second side panel 116, and an inside of the cabinet 11 is a hollow structure that may form space. A heat exchange component 20 may be disposed in the space formed by defining the cabinet 11, and the heat exchange component 20 may divide the space in the cabinet 11 into two independent spaces. Sizes of the two spaces in the cabinet 11 may be the same or different. In a specific implementation, placement of the heat exchange component 20 in the cabinet 11 may be set based on service requirements.

In a possible implementation, the heat exchange component 20 may determine placement of the heat exchange component 20 in the chassis 11 based on a height of a to-be-placed electronic device in the edge device and a size of a printed circuit board on which the electronic device is located. For ease of description, space in which the electronic device and the printed circuit board are placed is referred to as a second space 13, and the other space is referred to as a first space 12. The heat exchange component 20 is configured to implement heat transfer between the first space 12 and the second space 13.

Specifically, refer to FIG. 1 and FIG. 3, when the heat exchange component 20 is disposed, the heat exchange component 20 may be disposed along a length direction (that is, a direction a in FIG. 1) of the cabinet 11. The heat exchange component 20 needs to maintain a sealed connection to an inner wall of the cabinet inside the cabinet, so that the heat exchange component 20 divides the space in the cabinet 11 into two independent spaces along a width direction (that is, a direction b in FIG. 1) of the cabinet 11. Refer to FIG. 1 and FIG. 3 together, the first space 12 may be formed by a part of the top panel 111, a part of the bottom panel 112, a part of the front end plate 113, a part of the rear cover plate 114, the first side panel 115, and the heat exchange component 20 of the cabinet 11. Specifically, refer to segments b 1, b2, and b3 in FIG. 3, a total size of the segments b1, b2, and b3 is a width b0 of the cabinet 11. The part of the top panel 111, the part of the bottom panel 112, the part of the front end plate 113, and the part of the rear cover plate 114 that form the first space 12 are the top panel 111, the bottom panel 112, the front end plate 113, and the rear cover plate 114 corresponding to the segment b 1 respectively. A part of the top panel 111 of the cabinet 11 forms a top wall of the first space 12. A part of the bottom panel 112 of the cabinet 11 forms a bottom wall of the first space 12. A part of the front end plate 113 of the cabinet 11 forms a first end plate 12a of the first space 12. A part of the rear cover plate 114 of the cabinet 11 forms a second end plate 12b of the first space 12. The first side panel 115 of the cabinet 11 forms a first side wall 12c of the first space 12. A first surface that is of the heat exchange component 20 and that faces the first side panel 115 forms a second side wall 12d of the first space 12.

Correspondingly, the second space 13 may be formed by a part of the top panel 111, a part of the bottom panel 112, a part of the front end plate 113, a part of the rear cover plate 114, the second side panel 116, and the heat exchange component 20 of the cabinet 11. Specifically, the part of the top panel 111, the part of the bottom panel 112, the part of the front end plate 113, and the part of the rear cover plate 114 that form the first space 12 are the top panel 111, the bottom panel 112, the front end plate 113, and the rear cover plate 114 corresponding to the segment b3 respectively. A specific formation relationship may be based on a formation of the first space 12. The second side panel 116 forms a side wall of the second space 13, and a second surface that is of the heat exchange component 20 and that faces the second space 13 forms another side wall of the second space 13. Other correspondences are not described herein again.

Optionally, the heat exchange component 20 may be disposed along the length direction (that is, the direction a in FIG. 1) of the cabinet 11, or may be disposed along the width direction (that is, the direction b in FIG. 1) of the cabinet 11. In this case, the heat exchange component 20 divides the space in the cabinet 11 into two independent spaces in the length direction (that is, the direction a in FIG. 1) of the cabinet 11. For ease of description, the following embodiments are described by using a disposing manner of the heat exchange component 20 shown in FIG. 3 as an example.

It should be noted that the edge device provided in this application may include more devices. For example, a power module for running an electronic device is further disposed in the second space. In other words, a type and a quantity of devices included in the edge device do not constitute a limitation on this application.

Next, refer to FIG. 1 to FIG. 3, a method for the edge device to achieve a temperature control function is further explained.

As shown in the figure, the first space 12 is provided with a first air inlet 121 and a first air outlet 122, and the first air inlet 121 and the first air outlet 122 are separately connected to an external environment. An airflow in the external environment may enter the first space 12 from the first air inlet 121, flow through a first surface of the heat exchange component 20, and then exit from the first air outlet 122. It may be understood that, the first air inlet 121 may be one opening or a plurality of openings. When the first air inlet 121 is a plurality of openings, for example, 2, 3, 5, 8, 10, 15, 20, 30, or more, the plurality of openings may be provided in an arrangement to form an array opening, for example, an array with one column and a plurality of rows or an array with a plurality of columns and a plurality of rows. Similarly, the first air outlet 122 may be one opening or a plurality of openings. When the first air outlet 122 is a plurality of openings, for example, 2, 3, 5, 8, 10, 15, 20, 30, or more, the plurality of openings may be provided in an arrangement to form an array opening, for example, an array with one column and a plurality of rows or an array with a plurality of columns and a plurality of rows. Sizes of the first air inlet 121 and the first air outlet 122 may be determined based on a size of the first end plate 12a of the first space 12. Sizes of openings of the first air inlet 121 and the first air outlet 122 should be less than the size of the first end plate 12a. A specific size is not limited herein.

Refer to FIG. 2, to effectively adjust a flow rate of an airflow in the first space 12, a first fan group 14 may be disposed in the first space 12, so that the airflow entering the first space 12 from the first air inlet 121 flows to the first air outlet 122 under an action of the first fan group 14.

Still refer to FIG. 2, the second space 13 is for placement of an electronic device 101 or the printed circuit board. To achieve the dustproof and waterproof functions of the chassis 10, the second space 13 needs to be in a sealed state, for example, the top panel 111, the bottom panel 112, the front end plate 113, the rear cover plate 114, the first side panel 115, and the heat exchange component 20 of the cabinet 11 may be connected sealingly. A sealing component (for example, a structure such as a sealing ring, a sealing gasket, or a sealing groove) may be disposed at a joint between the top panel 111, the bottom panel 112, the front end plate 113, the rear cover plate 114, the first side panel 115, and the heat exchange component 20, to seal and prevent dust or liquid from causing corrosion to the electronic device 101 or the printed circuit board.

Based on the foregoing structure, because the first space 12 and the second space 13 are independent of each other, when a temperature of an outdoor environment in which the edge device is located is excessively high, or a temperature in the second space 13 is high due to heat generated by the electronic device 101 or the printed circuit board in a working process, and the edge device needs to dissipate heat, the heat may be transferred to the first space 12 by using the heat exchange component 20, and then the heat is transferred to the external environment of the edge device by using an external circulation airflow flowing in the first space 12, to implement heat dissipation for the electronic device 101 or the printed circuit board. When a temperature of an environment in which the edge device is located is low, an external airflow may be reduced to directly act on the second space 13, and a large amount of heat loss in the second space 13 is caused. In this way, the edge device can achieve a good temperature control function, so that the edge device can adapt to changes of different environments, achieve better temperature applicability, and broaden a temperature application arrange of the edge device.

To achieve a better temperature control effect, the edge device provided in this application may control air intake speed by changing an air intake mode. The following describes an air intake mode in the first space 12 in this application in detail with reference to FIG. 2 and FIG. 3.

To reduce natural air intake speed in a low-temperature environment, in embodiments of this application, the air intake speed in the first space 12 may be controlled through corner air intake. Specifically, the first air inlet 121 may be provided on the first side panel 115 of the cabinet 11, in other words, provided on the first side wall 12c of the first space 12, and runs through the first side panel 115 in a thickness direction of the first side panel 115. The first air inlet 121 is provided on an end that is of the first side wall 12c and that is far away from the rear cover plate 114, on other words, provided on an end that is of the first side wall 12c and that is close to the front end plate 113. The first air outlet 122 may be provided on the rear cover plate 114 of the cabinet 11, in other words, provided on the second end plate 12b of the first space 12, and runs through the rear cover plate 114 in a thickness direction of the rear cover plate 114. Because the first side panel 115 and the rear cover plate 114 are not disposed in parallel, the first side panel 115 and the rear cover plate 114 may be connected at a set angle, and the set angle may be selected, for example, in a range of 10° to 170°, for example, 90° may be preferably selected. In this way, the first air inlet 121 and the first air outlet 122 may be located in different planes, and are not disposed relatively parallel. In this way, an amount of air intake and a flow rate of an airflow of the first space 12 are controlled by using the angle corner air intake, and an airflow entering the cabinet 11 from the first air inlet 121 needs to be diverted and then exits from the first air outlet 122. The first air inlet 121 and the first air outlet 122 are not disposed in parallel, so that a direct ventilation structure may be avoided to turn to air intake, thereby increasing a distance at which an amount of air in per unit enters the first space, reducing a flow rate of an airflow in the first space 12, controlling an air intake volume in the first space 12 per unit time, and reducing a ventilation and heat exchange effect in a low-temperature environment.

Next, with reference to FIG. 4, a method for implementing corner air intake is further described. FIG. 4 is a schematic diagram of a structure of a first air inlet 121 according to this application. As shown in the figure, the first air inlet 121 may be provided on the front end plate 113 of the cabinet 11, that is, a first end plate of the first space 12, and the first air inlet 121 runs through the front end plate 113 in a thickness direction of the front end plate 113. The first air inlet 121 may be one opening or a plurality of openings. When the first air inlet 121 is a plurality of openings, for example, 2, 3, 5, 8, 10, 15, 20, 30, or more, the plurality of openings may be provided in an arrangement to form an array opening, for example, an array with one column and a plurality of rows or an array with a plurality of columns and a plurality of rows. A baffle plate 117 may be disposed outside of the cabinet 11, the baffle plate 117 may be disposed outside of the front end plate 113 and may be connected to the front end plate 113, and the baffle plate 117 and the front end plate 113 may enclose to form an air guide passage. For example, the baffle plate 117 may be an L-shaped plate or an arc-shaped plate, and at least one air guide opening exists in the air guide passage. An included angle is formed between an air intake direction of the air guide opening and an air intake direction of the first air inlet 121, to enable an airflow entering the air guide passage through the air guide opening to enter the cabinet from the first air inlet 121 after the airflow is diverted. In this embodiment, the air intake baffle plate 117 is disposed to implement angle air intake. This may reduce an amount of air inlet, facilitate reducing a heat loss in a low-temperature environment and improve a temperature control effect.

In a possible embodiment, the edge device provided in this application may further achieve a temperature control function of the chassis in a low-temperature environment by using an opening and closing component. Still refer to FIG. 2, the chassis 10 according to an embodiment of this application may further include an opening and closing component 30, and the opening and closing component 30 may be fixedly connected to the cabinet 11. The opening and closing component 30 may be disposed on at least one of the first air inlet 121, the first air outlet 122, or the first space 12, so that the opening and closing component 30 can control passage of an airflow between the first air inlet 121 and the first air outlet 122, to achieve a temperature control function in the chassis.

Because the temperature inside the cabinet 11 is affected by the external environment temperature of the edge device and the heat dissipation condition of the electronic device in the chassis, the temperature may be too high or too low. To ensure that the electronic device can work normally, the temperature inside the cabinet 11 may be monitored to control opening or closing of the opening and closing component. Specifically, when the temperature in the cabinet 11 is higher than the first temperature, the opening and closing component 30 is in a first structure, and in the first structure, the opening and closing component 30 may enable flow of the airflow between the first air inlet and the first air outlet. When the temperature in the cabinet 11 is lower than the second temperature, the opening and closing component 30 is in a second structure, and in the second structure, the opening and closing component 30 may block flow of the airflow between the first air inlet and the first air outlet. The first temperature and the second temperature may be the same or may be different. When the first temperature is the same as the second temperature, and when the temperature in the cabinet 11 is higher than the first temperature, the opening and closing component 30 may be opened, so that the airflow between the first air inlet 121 and the first air outlet 122 can flow. When the temperature in the cabinet 11 is lower than the first temperature, the opening and closing component 30 may be closed, to block flow of the airflow between the first air inlet 121 and the first air outlet 122, reduce heat dissipation, and achieve a temperature control function. When the first temperature is different from the second temperature, opening of the opening and closing component 30 may be controlled based on the first temperature, and closing of the opening and closing component 30 may be controlled based on the second temperature. In this case, the second temperature needs to be lower than the first temperature. It should be noted that the first temperature and the second temperature may be set based on a temperature at which the electronic device in the edge device can work normally.

For example, as shown in FIG. 2, the opening and closing component 30 may be disposed at the first air outlet 122. The opening and closing component 30 may control opening and closing of the first air outlet 122, to control flow and blocking of the airflow between the first air inlet 121 and the first air outlet 122. When the temperature in the cabinet 11 is low, for example, lower than the second temperature, the opening and closing component 30 automatically closes to block the first air outlet 122, to block flow of an airflow in the first space 12, reduce heat dissipation, and enable the edge device to run normally.

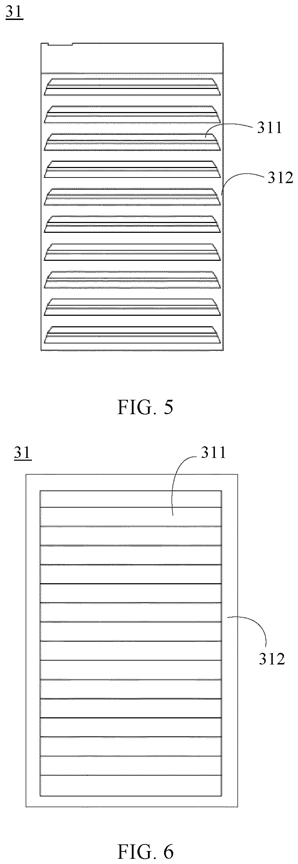

The following describes a specific structure of an opening and closing component in this application in detail with reference to FIG. 5 to FIG. 7.

In a possible implementation, the opening and closing component may use a shutter structure. FIG. 5 is a schematic diagram of a structure of a shutter according to this application. As shown in FIG. 5, in an embodiment of this application, an opening and closing component 30 is a shutter 31, and the shutter 31 may include a blade 311. There is/are 1, 2, 3, 4, 5, or more blades 311. This is not listed one by one herein. In an embodiment of this application, a plurality of the blades 311 are preferably set. When the shutter 31 is in an open state, in the plurality of blades 311, gaps may exist between every two adjacent blades 311, lengths of the gaps may be the same as a length of the blade 311, and widths of the gaps may be the same as a center spacing between the two adjacent blades 311, so that an airflow in the first space 12 exits from the first space 12. When the shutter 31 is in a closed state, in the plurality of blades 311, two adjacent blades 311 are closed, to close the first air outlet 122 and block flow of the airflow in the first space 12. Two ends of the blade 311 may be directly connected to the cabinet 11. It should be noted that, when the blade 311 is connected to the cabinet 11, it needs to be ensured that the blade 311 can be warped and deformed after being heated, and the gaps are formed between every two adjacent blades 311.

Next, with reference to FIG. 5, a connection and fixing manner of the blade 311 is described. Refer to FIG. 5, in a possible embodiment of this application, the blade 311 may be further connected to the cabinet 11 by using a frame 312. Specifically, in this connection, in addition to the blade 311, the shutter 31 may further include the frame 312. The blade 311 is connected to the frame 312, and the frame 312 is connected to the cabinet 11. The structure facilitates separate processing of the shutter 31. During an installation, an installed shutter 31 is directly fixedly connected to the cabinet 11 at the first air outlet 122.

In an embodiment of this application, the blade 311 may be made of a memory alloy. When a temperature of the blade 311 is lower than a third temperature, two adjacent blades 311 are closed, to prevent an airflow from exiting from the first air outlet 122. The third temperature may be a deformation temperature of the memory alloy, and may be determined by an attribute of the memory alloy. FIG. 6 is a schematic diagram of a structure of some blades 311 in a closed state of the shutter 31 according to an embodiment of this application. As shown in the figure, in an embodiment of this application, when the shutter 31 is in a closed state, when the plurality of blades 311 are disposed, the plurality of blades 311 are disposed in sequence along a height direction of the cabinet 11, and some overlapping areas may exist between every two of the plurality of blades 311, for example, in a direction from a top panel 111 to a bottom panel 112 of the cabinet 11. Some areas of the first blade 311 may be pressed by the second blade 311, some areas of the second blade 311 may be pressed by the second blade 311, and so on, to block the first air outlet 122. When the temperature of the blade 311 is higher than the third temperature, the blade 311 is deformed by heat and expands outwards, and an opening is formed between two adjacent blades 311, to open the first air outlet 122.

It should be noted that, in the foregoing embodiment, the blade is disposed in the chassis, and both an environment temperature of the edge device and a temperature in the cabinet affect the temperature of the blades. Therefore, when the memory alloy is used as the blade and the temperature of the blade reaches the third temperature, the blades is in a closed state, so that an airflow can be prevented from exiting from the first air outlet, to achieve an effect of "heat insulation" on the chassis.

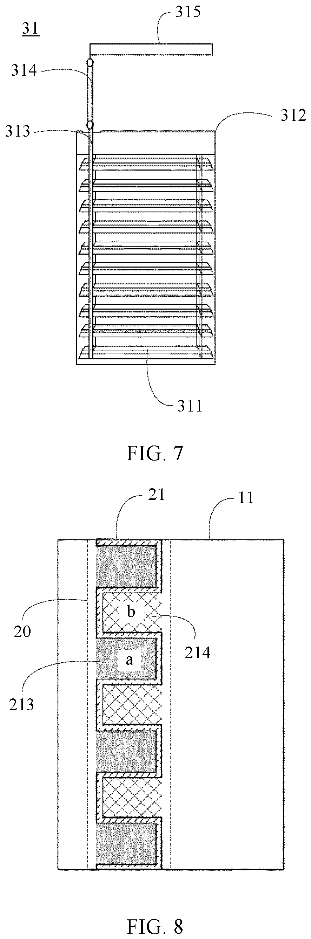

In a possible embodiment, in addition to a shutter structure used the memory alloy, the opening and closing component may be implemented by using a shutter structure including a pull cable. FIG. 7 is a schematic diagram of a structure of an opening and closing component according to another embodiment of this application. As shown in the figure, the opening and closing component 30 includes the shutter 31. The shutter 31 includes the blade 311 and the pull cable 313 connected to the blade 311. There may be a plurality of blades 311, and the plurality of blades 311 are all connected to the pull cable 313. The blade 311 may rotate relative to the cabinet 11, and when the pull cable 313 is pulled, the blade 311 may rotate. For example, a controller may be used to pull the pull cable. When the controller obtains a control signal indicating that the shutter 31 needs to be closed, the controller controls the pull cable 313, so that the blade 311 rotates to close the shutter 31. When the blade 311 rotates to a horizontal state, the shutter 31 may be in an open state, and the first air outlet 122 is opened. When the blade 311 rotates to a vertical state, the shutter 31 is in a closed state, and the first air outlet 122 is blocked. In an embodiment of this application, the shutter 31 may further include the frame 312, both two ends of any blade 311 are rotatably connected to the frame 312, and the frame 312 is fixedly connected to the cabinet 11. The pull cable 313 may be fixedly connected to the cabinet 11, for example, may be fixedly connected to the cabinet 11 by using a fixing rod 315, or may be fixedly connected to the frame 312.

Still according to FIG. 7, in a possible embodiment of this application, the opening and closing component 30 may further include a control member 314, and the control member 314 may be disposed on the pull cable 313. The control member 314 may be made of a memory alloy, for example, may be a memory alloy spring. The memory alloy spring may be disposed at an end of the pull cable 313, and may also be disposed at a middle part of the pull cable 313. When an environment temperature of the memory alloy spring is lower than a preset temperature, for example, a fourth temperature, the memory alloy spring is in a shrinkage state. In this case, the blade 311 is in a vertical closed state, and the first air outlet 122 is blocked. When the environment temperature of the memory alloy spring gradually increases, and when the temperature is higher than the fourth temperature, the memory alloy spring expands and deforms. In this case, an elastic force generated by the memory alloy spring may act on the pull cable 313, so that the pull cable 313 moves up and down in a vertical direction. Driven by the pull cable 313, the blade 311 rotates, for example, may rotate from a vertical state to a horizontal state gradually. A rotation angle of the blade 311 may be determined by a magnitude of a deformation of the memory alloy spring. When the temperature of the memory alloy spring is high, a deformation generated by the memory alloy spring is large. In this case, displacement of the pull cable 313 is large, and an angle for driving the blade 311 to rotate is also large.

The air intake mode and a structure of the opening and closing component 30 may achieve a better temperature control function for ventilation and heat dissipation of the first space 12, and heat generated by the second space 13 needs to be transferred to the first space 12 through the heat exchange component 20. The following describes a specific structure of the heat exchange component 20 in the chassis 11 in this application in detail with reference to FIG. 8 to FIG. 12.

In a possible implementation, FIG. 8 provides a schematic diagram of a structure of a side view of a heat exchange component, which may be a schematic diagram of a structure in the cabinet from a side of the first end plate 113 along a direction a in the structure shown in FIG. 1. For ease of observation, FIG. 8 only shows the heat exchange component in the cabinet 11, and other members are not shown. As shown in FIG. 8, in an embodiment of this application, the heat exchange component 20 includes a heat exchange plate 21, and the heat exchange plate 21 may be an arch-shaped heat exchange plate. One or more first air passages 213 may be formed, by using a bending shape of the heat exchange plate 21, on a side that is of the heat exchange plate 21 and that faces the first space 12. The following specifically describes formation of the first air passage 213 with reference to FIG. 8. Refer to FIG. 8, a first surface of the heat exchange plate 21 is disposed facing the first space 12. The first surface protrudes towards the second space 13 to form a space area a, and the space area a further forms the first air passage 213. The first air passage 213 includes an air inlet and an air outlet, a first surface of the heat exchange plate 21 forms a part of a side wall of the first air passage 213, and the first air passage 213 may enable an airflow in the first space 12 to flow in the first air passage

Still refer to FIG. 8, correspondingly, a second surface of the heat exchange plate 21 is disposed facing the second space 13, and a space area b formed by the second surface protruding towards the first space 12 forms a second air passage 214. In the second space 13, the second surface of the heat exchange plate 21 forms a part of a side wall of the second air passage 214, and the second air passage 214 may be used for flow of an airflow in the second space 13. Compared with a heat exchange plate with a flat structure, the heat exchange plate 21 is an arch-shaped heat exchange plate, increasing a heat exchange area and improving a heat exchange effect.

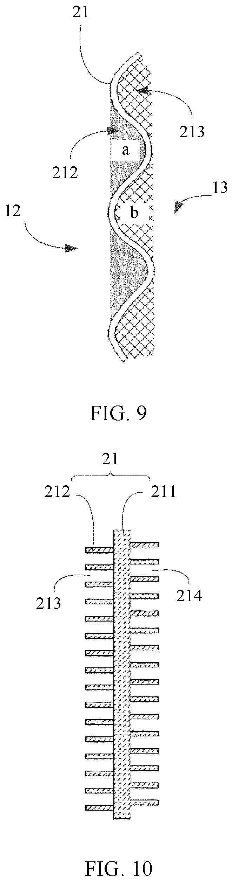

In a possible embodiment, in addition to the arch-shaped heat exchange plate shown in FIG. 8, this application further provides a structure with another heat exchange plate. FIG. 9 is a schematic diagram of a structure of another heat exchange plate 21 according to this application. A difference from FIG. 8 lies in a specific shape of the heat exchange plate. The heat exchange plate in FIG. 8 may be replaced with a heat exchange plate shown in FIG. 9, and other structures of the chassis may be the same. In an embodiment of this application, the heat exchange plate 21 may be an S-shaped heat exchange plate 21. Refer to the descriptions of the arch-shaped heat exchange plate, when the heat exchange plate 21 is the S-shaped heat exchange plate, a first surface of the heat exchange plate 21 is disposed facing the first space 12, and a space area a formed by the first surface protruding towards the second space 13 forms the first air passage 213. In the first space 12, a first surface of the heat exchange plate 21 forms a part of a side wall of the first air passage 213, and the first air passage 213 may be used for flow of an airflow in the first space 12. Correspondingly, a second surface of the heat exchange plate 21 is disposed facing the second space 13, and a space area b formed by the second surface protruding towards the first space 12 forms the second air passage 214. In the second space 13, the second surface of the heat exchange plate 21 forms a part of a side wall of the second air passage 214, and the second air passage 214 may be used for flow of an airflow in the second space 13. Compared with a heat exchange plate with a flat structure, the heat exchange plate 21 is an S-shaped heat exchange plate 21 or an arch-shaped heat exchange plate 21, increasing a heat exchange area and improving a heat exchange effect.

In a possible embodiment, in addition to the heat exchange plate structures shown in FIG. 8 and FIG. 9, this application further provides a structure with another heat exchange plate. FIG. 10 is a schematic diagram of a structure of a heat exchange plate 21 according to another embodiment of this application. As shown in the figure, in an embodiment of this application, the heat exchange plate 21 includes a middle partition plate 211, and a plurality of dental plates 212 disposed at intervals are disposed on both two sides of the middle partition plate 211. The first air passage 213 is formed between the plurality of dental plates 212 disposed near the first space 12 of the middle partition plate 211. The second air passage 214 is formed between the plurality of dental plates 212 disposed near the second space 13 of the middle partition plate 211.

It may be understood that, in addition to the structure shown in any one of FIG. 8 to FIG. 10, a structure of the heat exchange plate 21 may further be a heat exchange plate 21 with another structure form, provided that heat exchange between the first space 12 and the second space 13 can be implemented.

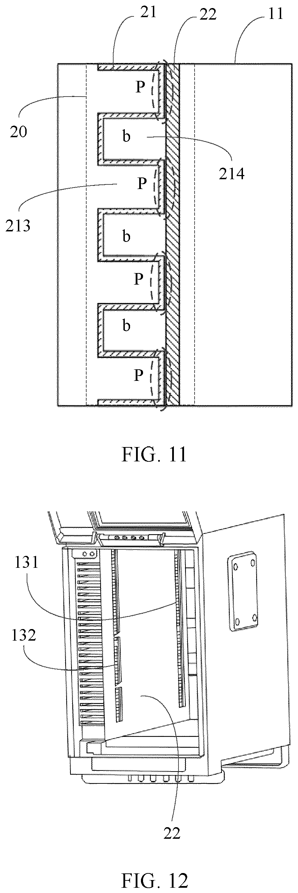

In a possible implementation, in addition to the heat exchange plate 21 in any one of FIG. 8 to FIG. 10, the heat exchange component 20 may further include a partition plate. A partition plate in a heat exchange component is further described in detail below with reference to FIG. 11 and FIG. 12.

FIG. 11 is a schematic diagram of a structure of a side view of a heat exchange component according to an embodiment of this application. As shown in the figure, the heat exchange component 20 may further include a partition plate 22, and the partition plate 22 may be configured to form the second air passage 214 together with the heat exchange plate 21. The partition plate 22 may be disposed on a side that is of the heat exchange plate 21 and that faces the second space 13. For example, the partition plate 22 may be connected to a second surface of the heat exchange plate 21. A gap between the heat exchange plate 21 and the partition plate 22 may form the second air passage 214. The partition plate 22 may be a flat plate structure. In this way, when the heat exchange plate 21 is a flat plate structure, the heat exchange plate 21 may be disposed at a specific spacing with the entire second surface of the partition plate 22. In in this case, the gap between the heat exchange plate 21 and the partition plate 22 may form the second air passage 214. When the heat exchange plate 21 is any structure shown in FIG. 8 to FIG. 10, in other words, when the heat exchange plate 21 is a non-plate structure, the partition plate 22 may directly contact a surface of some areas of the heat exchange plate 21. Using the arch-shaped heat exchange plate as an example, the partition plate 22 may contact an area P in FIG. 11. In this case, space (an area b shown in FIG. 11) formed between the heat exchange plate 21 and the partition plate 22 may form the second air passage 214. When the heat exchange plate 21 is a non-flat plate structure, the partition plate 22 may also be separated by a specific distance from the entire second surface of the heat exchange plate 21, to form the second air passage 214.

Next, with reference to FIG. 12, a structure of the partition plate and a position of the partition plate in the cabinet are further described. FIG. 12 is a schematic diagram of a three-dimensional structure inside a chassis 10 according to an embodiment of this application. Refer to FIG. 11 and FIG. 12 together, in an embodiment of this application, the partition plate 22 is provided with a second air inlet 131 and a second air outlet 132, and an airflow in the second space 13 may enter the second air passage 214 through the second air inlet 131, and exit from the second air outlet 132 through the second air passage 214, and then circularly enter the second space 13 again, so that the airflow in the second space 13 implements internal circulation flow and heat exchange.

Still refer to FIG. 12, in an embodiment of this application, along a length direction of the partition plate 22, and refer to FIG. 1 together, the length direction of the partition plate 22 is a length direction of the cabinet 11. The second air inlet 131 is provided on a side of the partition plate 22 that is close to a rear cover plate 114, and the second air outlet 132 is disposed on a side of the partition plate 22 that is close to the front end plate 113. In other words, along the length direction of the partition plate 22, a distance between the second air inlet 131 and the rear cover plate 114 is less than a distance between the second air outlet 132 and the rear cover plate 114. In other words, a distance between the second air inlet 131 and the first air outlet 122 is less than a distance between the second air outlet 132 and the first air outlet 122. In this way, a direction from the first air inlet 121 to the first air outlet 122 is defined as a first direction, and a direction from the second air inlet 131 to the second air outlet 132 is defined as a second direction. In this case, the first direction is opposite to the second direction. Therefore, in a heat exchange process, an airflow direction of the first air passage 213 is opposite to an airflow direction of the second air passage 214, to improve heat exchange efficiency.

To enable a gas in the second space to flow and control a flow rate of an airflow in the second space, a second fan group may be disposed in the second space. The following continues to describe the second fan group in the second space in this application with reference to FIG. 2. As shown in FIG. 3, in a possible embodiment of this application, a second fan group 15 is disposed in the second space 13, the second fan group 15 may include at least one fan, and an airflow in the second space 13 flows under an action of the second fan group 15. A flow rate of an airflow in the second space 13 may be increased by disposing the second fan group 15, thereby improving heat exchange efficiency.

To enable an electronic device disposed in the second space to normally start and run in a low-temperature environment, a heating component is further disposed in the chassis in this application. The following further describes the heating component of the chassis in this application with reference to FIG. 2. Still refer to FIG. 2, in an embodiment of this application, a heating component 16 may be further disposed in the second space 13, and the heating component 16 is configured to provide heat for the second space 13. For example, a temperature sensor may be disposed to detect a temperature in the cabinet, and when the temperature sensor detects that a temperature in the second space is lower than a specific temperature, for example, 0°C, a control member of the edge device, for example, a controller, may be configured to start the heating component 16, to heat the second space 13, to prevent the electronic device in the second space 13 from stopping running due to an excessively low temperature. Specifically, in an embodiment of this application, the heating component 16 may include a heating film, and there may be one or more heating films. Any heating film may be disposed on a side wall of the second space 13, for example, an inner side wall. A specific position on an inner wall of the second space 13 may be disposed based on an installation position of the electronic device or a printed circuit board in which the electronic device is located. This is not specifically limited herein. In addition to the heating film, the heating component 16 may further be provided with members such as a heating line and a heating power supply. Optionally, to improve heating efficiency, a plurality of heating films may be disposed on a same side wall.

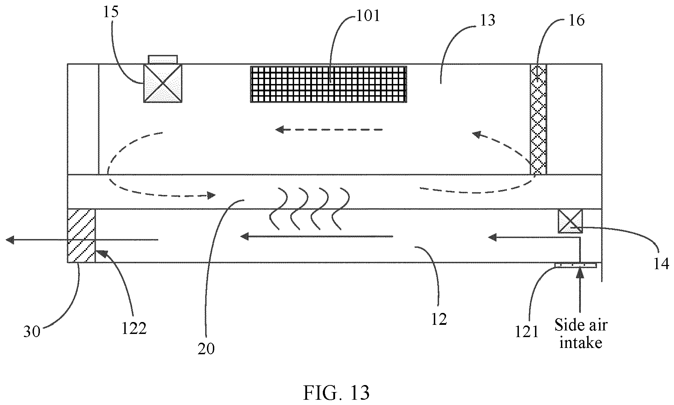

Based on the structure and similar design of the foregoing chassis, this application further provides an edge device. FIG. 13 is a schematic diagram of a structure of a top view of an edge device according to this application. As shown in the figure, a system apparatus 100 may include the chassis 10 in the foregoing possible embodiments of this application, an electronic device 101 may be disposed in a second space 13 of the chassis 10, and the electronic device 101 may be disposed on the printed circuit board 101.

Based on the foregoing descriptions in FIG. 1 to FIG. 13, the chassis and the edge device provided in this application can provide an effective temperature control function in different environments, so that an electronic device can still work normally in a harsh environment, and applicability is wider.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A chassis, comprising a cabinet and a heat exchange component, wherein the heat exchange component is disposed in the cabinet, the heat exchange component divides a space in the cabinet into a first space and a second space for placement of an electronic device, and heat transfer is performed between the first space and the second space by using the heat exchange component; and
a first air inlet and a first air outlet are provided in the first space, an airflow entering from the first air inlet flows through a first surface of the heat exchange component and exits from the first air outlet, and the first surface is located in the first space.

2. The chassis according to claim 1, wherein a baffle plate is disposed outside the cabinet, and the baffle plate is configured to control the airflow from the first air inlet to enter the cabinet through corner air intake.

3. The chassis according to claim 2, wherein the first air inlet is provided on a first end plate of the first space, the baffle plate is connected to the first end plate, and the baffle plate and the first end plate enclose to form an air guide passage, at least one air guide opening exists in the air guide passage, and an included angle is provided between an air intake direction of the air guide opening and an air intake direction of the first air inlet, to enable an airflow entering the air guide passage through the air guide opening to enter the cabinet from the first air inlet after the airflow is diverted.

4. The chassis according to claim 2, wherein the baffle plate is an L-shaped plate or an arc-shaped plate.

5. The chassis according to claim 1, wherein the first air inlet is provided on a first side wall of the first space, the first air outlet is provided on a second end plate of the first space, and an included angle is provided between the first side wall and the second end plate, to enable the airflow entering from the first air inlet to exit from the first air outlet after the airflow is diverted.

6. The chassis according to any one of claims 1 to 5, wherein a first fan group is disposed in the first space, and an airflow entering the first space from the first air inlet flows to the first air outlet under an action of the first fan group

7. The chassis according to any one of claims 1 to 6, wherein the chassis further comprises an opening and closing component, the opening and closing component is connected to the cabinet, and the opening and closing component is configured to control passage of an airflow between the first air inlet and the first air outlet to achieve a temperature control function in the chassis.

8. The chassis according to claim 7, wherein the opening and closing component is in a first structure when a temperature in the cabinet is higher than a first temperature, wherein the first structure enables flow of the airflow between the first air inlet and the first air outlet; and the opening and closing component is in a second structure when the temperature in the cabinet is lower than a second temperature, wherein the second structure blocks flow of the airflow between the first air inlet and the first air outlet.

9. The chassis according to claim 8, wherein the first temperature is the same as the second temperature.

10. The chassis according to claim 8, wherein the first temperature is different from the second temperature, and the first temperature is higher than the second temperature.

11. The chassis according to any one of claims 7 to 10, wherein the opening and closing component is disposed at the first air outlet, and opening and closing of the first air outlet is controlled through the opening and closing component.

12. The chassis according to claim 7, wherein the opening and closing component comprises a shutter, the shutter comprises a blade, the blade is connected to the cabinet, a material of the blade is a memory alloy, the blade expands when a temperature of the blade is higher than a third temperature, to open the first air outlet, and the blade shrinks when a temperature of the blade is lower than the third temperature, to close the first air outlet.

13. The chassis according to claim 7, wherein the opening and closing component comprises a shutter, the shutter comprises a blade and a pull cable connected to the blade, the pull cable is fixedly connected to the cabinet, and the blade is rotatably connected to the cabinet; and
a control member is disposed on the pull cable, the control member is a control member made of a memory alloy, the control member expands when a temperature of the control member is higher than a fourth temperature, wherein the pull cable drives the blade to rotate to enable the first air outlet to be in an open state, and the control member shrinks when the temperature of the control member is lower than the fourth temperature, wherein the pull cable drives the blade to rotate to enable the first air outlet to be in a closed state.

14. The chassis according to claim 13, wherein the control member is a memory alloy spring.

15. The chassis according to any one of claims 1 to 14, wherein a heating component is disposed in the second space, and the heating component is configured to increase a temperature of the second space in a low-temperature environment.

16. The chassis according to claim 15, wherein the heating component comprises a heating film, and the heating film is disposed in the second space.

17. The chassis according to claim 16, wherein the heating film is disposed on at least one position in a bottom wall or a side wall of the second space.

18. The chassis according to any one of claims 1 to 17, wherein a second fan group is disposed in the second space, and an airflow in the second space flows under an action of the second fan group.

19. The chassis according to any one of claims 1 to 18, wherein the heat exchange component comprises a heat exchange plate, a first air passage is disposed on a side that is of the heat exchange plate and that faces the first space, and a second air passage is disposed on a side that is of the heat exchange plate and that faces the second space.

20. The chassis according to claim 19, wherein the heat exchange plate is an S-shaped heat exchange plate.

21. The chassis according to claim 19, wherein the heat exchange plate is an arch-shaped heat exchange plate.

22. The chassis according to claim 19, wherein the heat exchange component further comprises a partition plate, the partition plate is disposed on a side that is of the heat exchange plate and that faces the second space, a gap is disposed between the partition plate and the heat exchange plate, and the gap forms the second air passage; and
the partition plate is provided with a second air inlet and a second air outlet, and the airflow in the second space enters the second air passage through the second air inlet, and enters the second space through the second air outlet.

23. The chassis according to claim 22, wherein a direction from the first air inlet to the first air outlet is a first direction, a direction from the second air inlet to the second air outlet is a second direction, and the first direction is opposite to the second direction.

24. The chassis according to any one of claims 1 to 23, wherein the chassis is a chassis of an edge device, and the edge device is a device configured to implement edge computing.

25. The chassis according to claim 24, wherein the edge device comprises an edge server, an edge small cell, an AI server, an AI accelerator card, a base station device, an intelligent terminal, or another device configured for edge computing.

26. An edge device, wherein the edge device comprises the chassis according to any one of claims 1 to 25.
